# EUROPÄISCHE PATENTSCHRIFT

(11) **EP 1 728 263 B1**
(45) Veröffentlichungstag und Bekanntmachung des Hinweises auf die Patenterteilung: **20.11.2013**
(21) Anmeldenummer: 05715583.0
(22) Anmeldetag: 26.02.2005
(51) Int. Cl.: H01J 37/32

(54) **Verfahren zum Erkennen von Bogenentladungen und Bogenentladungserkennungseinrichtung**
Method of detecting arc discharges and arc discharge detection device
Procédé de détection de décharge en arc et dispositif de détection de décharge en arc

(30) Priorität: 25.03.2004 DE 102004015090
(43) Veröffentlichungstag der Anmeldung: 06.12.2006
(73) Patentinhaber: TRUMPF Hüttinger GmbH + Co. KG, 79111 Freiburg im Breisgau (DE)
(72) Erfinder: WINTERHALTER, Markus, 79189 Bad Krozingen (DE); WIEDEMUTH, Peter, 79336 Herbolzheim (DE)
(74) Vertreter: Schiz, Jochen
(86) Internationale Anmeldenummer: PCT/EP2005/002069
(87) Internationale Veröffentlichungsnummer: WO 2005/096344

(56) Entgegenhaltungen:
- WO-A-03/037047
- DE-A1- 4 127 504
- DE-A1- 10 034 895
- DE-A1- 10 119 058
- JP-A- 2000 117 146
- US-A- 5 993 615
- US-B1- 6 332 961
- PATENT ABSTRACTS OF JAPAN Bd. 1996, Nr. 10, 31. Oktober 1996 (1996-10-31) & JP 08 167500 A (JEOL LTD), 25. Juni 1996 (1996-06-25)

## Beschreibung

Die Erfindung betrifft eine Bogenentladungserkennungseinrichtung und ein Verfahren zum Erkennen von Bogenentladungen in einem Plasmaprozess, bei dem ein Momentanwert eines Signals mit einem in einem vorgegebenen Zeitraum aus dem Signal ermittelten Wert verglichen wird.

Plasmaprozesse kommen beispielsweise in Plasma-Bearbeitungs- und Beschichtungsvorrichtungen vor. Bei Gleichstrom-Sputteranlagen kommt es oft zu Überschlägen, bei denen sich ein Strom einen elektrisch leitenden Kanal im Plasma sucht. Insbesondere bei dem so genannten reaktiven Beschichten eines Substrats, treten derartige Überschläge relativ oft auf. Ursache hierfür ist der Umstand, dass neben dem Substrat selbst auch Teile der Sputteranlage, wie etwa die Innenwand der Prozesskammer oder Teile von Blenden mit elektrisch nicht leitenden oder schlecht leitenden Materialien beschichtet werden, die sich dann bis zu einer Durchbruchspannung aufla-den. Um größeren Schaden von einer Sputteranlage fernzuhalten, wird deshalb die Stromzufuhr nach dem Auftreten eines Überschlags abgeschaltet oder der Strom kurzzeitig unterbrochen oder die Spannung an der Plasmakammer kurzgeschlossen oder umgepolt. Um diese Maßnahmen einleiten zu können, sind Anordnungen zur Bogenentladungserkennung (Arc-Erkennung) und zur Löschung der Bogenentladungen (Arcs) oft Bestandteil der Plasmastromversorgung.

Wichtig dabei ist die zuverlässige Erkennung von Arcs. Ein Arc kann erkannt werden durch einen Spannungseinbruch oder einen Stromanstieg am Ausgang der Plasmastromversorgung. Es ist bekannt, für die am Ausgang der Plasmastromversorgung gemessene Spannung einen Schwellwert manuell vorzugeben, bei dessen Unterschreiten ein Arc erkannt wird. Genauso bekannt ist es, für den am Ausgang der Plasmastromversorgung gemessenen Strom einen Schwellwert manuell vorzugeben, bei dessen Überschreiten ein Arc erkannt wird.

In der DE 41 27 504 A1 wird eine Schaltungsanordnung zur Unterdrückung von Arcs beschrieben, bei der der Augenblickswert der Spannung der Plasmastrecke mit einem Spannungswert verglichen wird, der einer über eine vorgegebene Zeit ermittelten mittleren Plasmaspannung entspricht. Übersteigt die Differenz zwischen dem Augenblickswert und dem ermittelten Mittelwert einen vorgegebenen Wert, so wird ein Arc erkannt und die Stromversorgung zur Plasmakammer unterbrochen.

Dabei muss der vorgegebene Wert, bei dem der Arc erkannt wird, groß genug sein, dass nicht irrtümlich die Restwelligkeit der Ausgangsspannung als Arc interpretiert wird. Bei Plasmaprozessen muss oftmals ein weiter Ausgangsspannungsbereich abgedeckt werden. Die Restwelligkeit kann von der Ausgangsspannung abhängig sein. Dann muss der vorgegebene Wert, bei dem der Arc erkannt wird, so groß sein dass auch bei größter Restwelligkeit dieser Wert nicht erreicht wird und keine fehlerhafte Arc-Meldung erzeugt wird.

Wird eine Stromversorgung eingeschaltet, so ist das Plasma zunächst noch nicht gezündet. Bei einer von Prozessparametern wie Druck und Geometrie abhängigen Spannung zündet das Plasma und der Lastwiderstand wechselt von sehr großen zu niedrigen Werten. Dies führt zu einem Spannungseinbruch, der mit der Schaltungsanordnung der DE 41 27 504 A1 irrtümlich als Arc interpretiert werden kann. Auch hier muss der Wert, dessen Erreichen dem Auftreten eines Arcs zugeordnet wird, groß genug sein, dass es zu keiner irrtümlichen Arc-Erkennung kommt. Alternativ kann die vorgegebene Zelt, über die der Mittelwert gebildet wird variiert werden, um ein irrtümliches Erkennen eines Arcs zu verhindern.

Damit sind die Werte, die eigentlich so eingestellt werden sollen, dass ein Arc sicher erkannt wird, von anderen Parametern abhängig, und können nicht mehr optimal gewählt werden.

In der EP 1 441 576 A1 sind ein Verfahren und eine Vorrichtung zum Erkennen von Bogenentladungen in einem Plasmaprozess beschrieben. Eine Vorwärtsspannung und eine reflektierte Spannung werden zunächst verstärkt, dann differenziert und In einem Komparator werden die differenzierten Signale miteinander verglichen bzw. subtrahiert. Wenn die Abweichung über einem vorgegebenen Wert Ilegt, wird ein Signal ausgegeben, das eine Stromversorgung abschaltet.

Die JP 2000117146 A offenbart ein Verfahren zum Erkennen von Bogenentladungen In einem Elektrofilter, in welchem es aufgrund des zwischen den Elektroden anliegenden elektrischen Felds zu Stoßionisationen und somit zur Ausbildung eines Plasmas kommt.

Die DE 100 34 895 A1 offenbart das Messen des zeitlichen Verlaufs der an mindestens einer zur Plasmaerzeugung erforderlichen Elektrode anliegenden Spannung. Die Zündspannung der Plasmaentladung wird ermittelt und dieser aktuelle Wert der Zündspannung wird mit dem Wert der Zündspannung der normal verlaufenden Plasmaentladung verglichen. Die Differenz zwischen den beiden Werten wird als Information zur Erkennung eines Überschlags genutzt. Weiterhin wird vorgeschlagen, den aktuellen Wert der Zündspannung mit dem Wert der Zündspannung der vorangegangenen Halbwelle zu vergleichen. Die Zündspannung wird durch Differenzieren des zeitlichen Verlaufs der Spannung für jede Halbwelle bestimmt.

Es ist Aufgabe der Erfindung ein Verfahren und eine Einrichtung bereit zu stellen, mit denen eine Bogenentladung in einem Plasmaprozess zuverlässig erkannt werden kann. Diese Aufgabe wird erfindungsgemäß durch ein Verfahren mit den Merkmalen des Anspruchs 1 gelöst.

Dies bedeutet, dass der Eintritt dieses Ereignisses als das Auftreten einer Bogenentladung interpretiert wird. Ob es sich bei dem ermittelten Extremwert um einen Momentanwert oder einen Maximalwert handelt, hängt davon ab, welches Signal für die Arc-Erkennung verwendet wird. Beispielsweise ist es denkbar, dass als Signal die Ausgangsspannung einer Gleichstromversorgung verwendet wird, die den Plasmaprozess mit Gleichstrom speist In einem solchen Fall würde der Minimalwert der Spannung über einen vorgegebenen Zeitraum ermittelt. Alternativ kann vorgesehen sein, dass der In den Plasmaprozess gespeiste Strom verwendet wird. In einem solchen Fall würde der Maximalwert des Stroms über einen vorgegebenen Zeitraum ermittelt. Von dem verwendeten Signal hängt es auch ab, ob der Referenzwert erreicht wird, indem der Momentanwert den Referenzwert übersteigt oder unter den Referenzwert fällt.

Wenn ein Minimalwert ermittelt wird, können der Momentanwert und der Minimalwert beispielsweise miteinander verglichen werden, indem deren Differenz gebildet wird und kann überprüft werden, ob die Differenz eine vorgegebene Abweichung übersteigt. Alternativ kann der Momentanwert mit einem Referenzwert verglichen werden, wobei in diesem Fall überwacht wird, ob der Momentanwert des Signals größer oder kleiner als der Referenzwert ist und, insbesondere wenn ein Minimalwert erfasst wird, eine Bogenentladung erkannt wird, wenn der Momentanwert den Referenzwert unterschreitet. Dazu muss der Referenzwert aus Minimalwert und vorgegebener Abweichung ermittelt werden. Durch die Extremwertbildung kann die Abweichung so gewählt werden, dass eine von der Ausgangsspannung oder dem Laststrom abhängige Restwelligkeit des Signals nicht mehr berücksichtigt werden muss.

Bevorzugten wird die vorgegebene Abweichung in Abhängigkeit des Extremwerts ermittelt. Dies bedeutet, dass die Abweichung permanent adaptiert wird, je nachdem welche Prozessbedingungen vorherrschen. Insbesondere müssen keine festen Abweichungen bzw. Referenzwerte vorgegeben werden, die für jeden Prozess neu eingestellt werden müssen. Dadurch wird die Benutzung einer Plasmaanlage sehr viel komfortabler.

Bei einer bevorzugten Weiterbildung des Verfahrens kann vorgesehen sein, dass die Abweichung als das 0,1- bis 0,5-fache, vorzugsweise das 0,2- bis 0,4-fache des Extremwerts gewählt wird. Durch diese Maßnahme wird ein Sicherheitsabstand geschaffen. Auf diese Art und Weise wird vermieden, dass Störungen auf dem Signal als Bogenentladung-interpretiert werden. Besonders bevorzugt ist es, wenn als Signal ein zu einer Ausgangsspannung einer Gleichspannungsversorgung proportionales Signal verwendet wird. Insbesondere kann die Ausgangsspannung durch einen Spannungsteiler auf eine niedrigere Spannung gebracht werden, so dass diese proportionale Spannung leichter durch eine Schaltungsanordnung verarbeitet werden kann. Weiterhin kann ein zum Ausgangsstrom proportionales Signal für die Bogenentladungserkennung verwendet werden. Wird der Ausgangsstrom oder ein dazu proportionales Signal für die Bogenentladungserkennung verwendet, dann muss ein Maximalwert des Signals gebildet werden, der dann mit dem Momentanwert des Signals verglichen wird. Wenn eine Differenz dieser Werte eine vorgebbare Abweichung übersteigt, wird dies als Auftreten einer Bogenentladung interpretiert.

Auf besonders einfache Art und Weise kann ein Extremwert über einen vorgegebenen Zeitraum ermittelt werden, wenn das Signal gefiltert wird. Eine derartige Extremwertermittlung kann besonders einfach schaltungstechnisch realisiert werden.

Bei einer bevorzugten Verfahrensvariante wird eine Minimalwertfilterung durchgeführt. Eine Minimalwertfilterung kann besonders einfach durchgeführt werden, wenn die Filterung für steigende und fallende Signalwerte mit unterschiedlichen Zeitkonstanten durchgeführt wird. Insbesondere, wenn eine Minimalwertfilterung durchgeführt wird, kann vorgesehen sein, dass bei einer steigenden Flanke, d.h. bei einer Veränderung des Signalpegels des Signals von einem niederen zu einem höheren Wert, eine größere Zeitkonstante verwendet wird, als bei einer fallenden Flanke, d.h. einer Veränderung des Signalpegels von einem hohen zu einem niedrigeren Wert. Durch die Zeitkonstanten wird der Zeitraum festgelegt, in dem der Minimalwert gesucht wird.

Die Minimalwertfilterung kann einstufig erfolgen. Dies hat einen geringen Bauteileaufwand als Vorteil. Alternativ kann die Minimalwertfilterung mehrstufig erfolgen. In diesem Fall kann eine niedrigere Restwelligkeit am Ausgang des Filters erreicht werden und ist ein schnelleres Einschwingen bei schnellen negativen Spannungsänderungen möglich.

Vorteilhafterweise wird überwacht, ob das Plasma des Plasma prozesses gezündet ist. Eine Bogenentladungserkennung macht überwiegend dann Sinn, wenn das Plasma des Plasmaprozesses gezündet ist. Ist das Plasma nicht gezündet, können keine Arcs auftreten. Spannungseinbrüche treten allenfalls beim Zünden des Plasmas auf, müssen da aber nicht erkannt werden. Das Verfahren zum Erkennen von Bogenentladungen muss daher nur durchgeführt werden, wenn das Plasma gezündet ist. Deshalb ist bei einer Weiterbildung des Verfahrens vorgesehen, dass eine Bogenentladungserkennung nur durchgeführt wird, wenn erkannt ist, dass das Plasma gezündet ist.

Besonders bevorzugt ist es, wenn die Extremwertfilterung bei gezündetem Plasma mit einer ersten Zeitkonstante und bei erloschenem Plasma mit einer zweiten Zeitkonstante erfolgt. Durch diese Maßnahme kann ein irrtümliches Erkennen von Arcs beim Zünden des Plasmas auf Grund von Spannungseinbrüchen oder Stromanstiegen verhindert werden.

Besonders vorteilhaft ist es, wenn ein fester Schwellenwert vorgegeben wird und eine Bogenentladung erkannt wird, wenn der Momentanwert den festen Schwellenwert erreicht. Dies kann bedeuten, dass bei einer Verfahrensvariante, in der die Ausgangsspannung oder eine dazu proportionale Spannung überwacht wird, also als Extremwert ein Minimalwert gesucht wird, das Unterschreiten des festen Schwellenwerts durch den Momentanwert als Auftreten einer Bogenentladung erkannt wird. Werden dagegen Maximalwerte als Extremwert erfasst, so kann vorgesehen sein, dass als Auftreten einer Bogenentladung interpretiert wird, wenn der Momentanwert den vorgebbaren festen Schwellenwert überschreitet. Durch diese Maßnahme können Bogenentladungen oder Kurzschlüsse erkannt werden, die sich nur sehr langsam entwickeln, z.B. auf Grund von Isolierstoffüberlastungen im Kabel.

Bei einer Ausgestaltung des Verfahrens kann vorgesehen sein, dass bei Erkennen einer Bogenentladung der Signalpegel eines Stromentladungserkennungssignals geändert wird. Das Bogenentladungserkennungssignal kann einer Steuerung, beispielsweise einem Mikroprozessor, zugeführt werden und es kann nach einer vorgegebenen Zeitspanne definiert auf die Erkennung der Bogenentladung reagiert werden. Es kann vorteilhaft sein, beim Erkennen einer Bogenentladung nicht sofort, sondern erst zeitverzögert auf die Erkennung der Bogenentladung zu reagieren, beispielsweise indem der Ausgang der Gleichstromversorgung kurzgeschlossen wird oder die Gleichstromversorgung ausgeschaltet wird. Die Maßnahmen, die getroffen werden, wenn eine Bogenentladung erkannt wird, werden durch die Steuerung bestimmt. Die zeitverzögerte Reaktion auf Bogenentladung ist vorteilhaft, wenn beispielsweise Verunreinigungen an der Target- oder Plasmakammeroberfläche den Arc haben entstehen lassen und diese Verunreinigungen durch die Zeitverzögerung definiert abgebrannt werden können. Die Zeitverzögerung kann bei vielen Plasmastromversorgungen vom Bedienpersonal eingestellt werden.

Bei einer Weiterführung des Verfahrens kann vorgesehen sein, dass der Signalpegel des Bogenentladungssignals zeitverzögert geändert wird, wenn die Bogenentladung erlischt. Durch diese Maßnahme wird eine Art Hysterese gebildet. Insbesondere wird verhindert, dass bei einer hohen Arc-Brennspannung das Bogenentladungssignal nach kurzer Zeit wieder zurückgesetzt wird. Dies ist besonders dann wichtig, wenn zeitverzögert auf eine das Auftreten eines Arcs anzeigende Änderung des Bogenentladungssignals reagiert wird.

Die Aufgabe wird außerdem gelöst durch eine Bogenentladungserkennungseinrichtung zum Erkennen von Bogenentladungen in einem Plasmaprozess mit den Merkmalen des Vorrichtungsanspruchs 14 gelöst. Das Signal ist einer Extremwerterfassungseinrichtung zum Ermitteln eines Extremwerts des Signals über einen vorgegebenen Zeitraum zugeführt. Aus dem Extremwert wird durch eine Einstelleinrichtung ein Referenzsignal erzeugt, das dem Vergleicher ebenso wie ein Momentanwert des Signals oder eines proportionalen Signals zugeführt ist, wobei der Vergleicher den Signalpegel des Bogenentladungserkennungssignals ändert, wenn der Vergleicher ein Erreichen des Referenzsignals durch den Momentanwert erkennt. Mit einer derartigen Einrichtung können Bogenentladungen zuverlässig erkannt werden, auch wenn das Signal sich während des Prozesses verändert und wenn das Signal eine gewisse Welligkeit bzw. Schwankungen aufweist.

Besonders vorteilhaft ist es, wenn die Bodenentladungserkennungseinrichtung eine Einstelleinrichtung zum Einstellen des Referenzwerts aufweist. Dies bedeutet, dass der Referenzwert in Abhängigkeit des Plasmaprozesses adaptiv angepasst werden kann, Eine Vorgabe fester Referenzwerte. die für unterschiedliche Prozesse Immer wieder neu eingestellt werden müssen, kann entfallen.

Besonders vorteilhaft ist es, wenn die Extremwerterfassungseinrichtung eine Filtereinrichtung umfasst. Mit einer Flitereinrichtung können Extremwerte über einen vorgegebenen Zeittraum auf einfache Art und - Welse ermittelt werden. Die filtereinrichtung kann dabei als Filter erster oder höherer Ordnung ausgeführt sein.

Bei einer bevorzugten Weiterbildung kann vorgesehen sein, dass die Filtereinrichtung ein RC-Glied aufweist, wobei parallel zu dem Widerstand des RC-Glieds ein zweiter Widerstand und ein dazu in Serie geschaltetes nichtlineares Bauteil, vorzugsweise eine Diode, vorgesehen sind. Mit einer derartigen Filtereinrichtung kann insbesondere ein Minimalwertfilter realisiert werden. Dadurch, dass zu dem Widerstand des RC-Glieds ein zweiter Widerstand parallel geschaltet ist, können unterschiedliche Zeitkonstanten für steigende und fallende Signalwerte verwendet werden. Insbesondere können eine hohe Anstiegszeitkonstante und eine niedrige Zeitkonstante beim Abklingen des Signals realisiert werden. Die Filterung verhindert, dass schnelle Signaländerungen, beispielsweise Spannungsänderungen bei Sollwertsprüngen, fehlerhaft als Arcs interpretiert werden.

Besonders vorteilhaft ist es, wenn die Filtereinrichtung mehrstufig ausgebildet ist. Mit der ersten Stufe werden eine hohe Restwelligkeit und ein langsames Abklingen bei schnellen Spannungsänderungen hin zu niedrigen Werten erreicht. Mit der zweiten Stufe und damit mit einem zweistufigen Filter kann eine geringe Restwelligkeit und ein schnelles Abklingen bei schnellen Spannungsänderungen hin zu niedrigen Werten realisiert werden. Der Bauteilaufwand bei einem zweistufigen Filter ist nur unwesentlich höher als bei einem einstufigen Filter.

Bei einer besonders vorteilhaften Ausgestaltung der Bogenentladungserkennungseinrichtung ist zwischen der Extremwerterfassungseinrichtung und dem Vergleicher ein erstes entkoppelndes Bauelement, insbesondere eine Diode angeordnet, und ist zwischen dem ersten entkoppelnden Element und dem Vergleicher über ein zweites entkoppelndes Element, insbesondere eine Diode, ein fester Schwellenwert, insbesondere eine Spannung eingekoppelt. Der Schwellenwert dient als Sicherheitsreserve bei niedrigen Ausgangsspannungen, um zu vermeiden, dass auftretende Arcs in solchen Situationen nicht erkannt werden. Weiterhin können anhand des festen Schwellenwerts Kurzschlüsse erkannt werden, die sich nur sehr langsam entwickeln, beispielsweise bei einer Isolierstoffüberlastung in Kabeln.

Wenn eine Hystereseschaltung zur Beeinflussung des an den Vergleicher gegebenen Momentanwerts des Signals vorgesehen ist, kann verhindert werden, dass bei hohen Arc-Brennspannungen das Bogenentladungserkennungssignal bereits nach kurzer Zeit wieder zurückgesetzt wird. Durch diese Maßnahme wird sichergestellt, dass der Arc tatsächlich erloschen ist, wenn das Bogenentladungserkennungssignal wieder seinen ursprünglichen, keinen Arc anzeigenden, Zustand einnimmt.

Vorteilhafterweise ist eine Plasmaerkennungseinrichtung vorgesehen, die mit einer Abschalteinrichtung zur Abschaltung der Bogenentladungserkennungseinrichtung verbunden ist. Mit einer derartigen Abschalteinrichtung kann die Bogenentladungserkennungseinrichtung eingeschaltet werden, wenn ein Plasma gezündet ist und daher Arcs auftreten können und zum anderen abgeschaltet werden, wenn das Plasma erloschen ist und daher in der Regel keine Arcs auftreten.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1.**: einen Schaltplan einer Bogenentladungserkennungseinrichtung;
- **Fig. 2**: ein Simulationsergebnis einer Simulation der Schaltungsanordnung der Fig. 1.

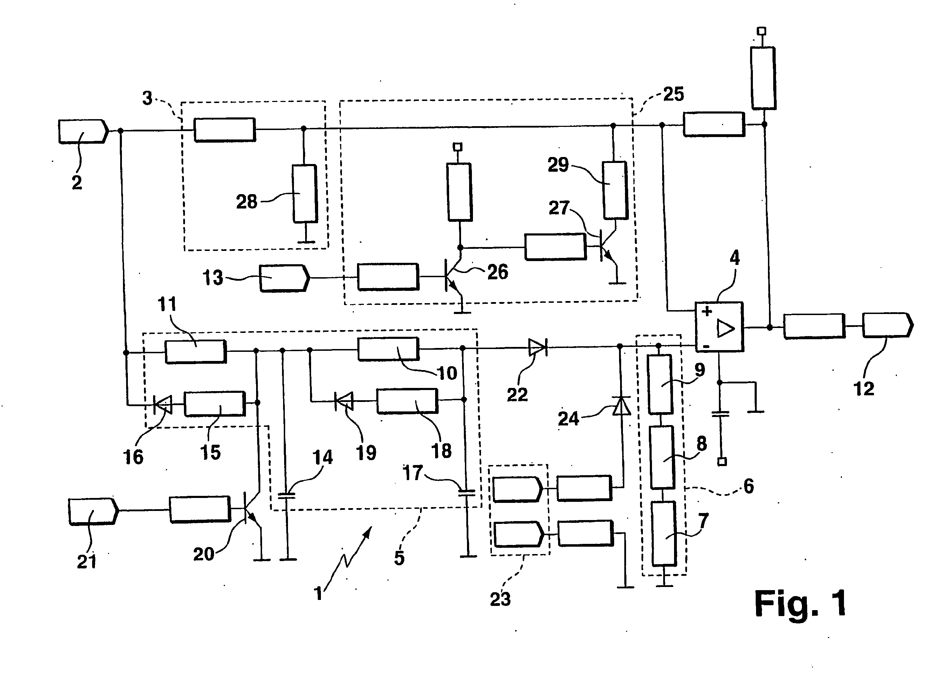

In der **Fig. 1** ist eine Bogenentladungserkennungseinrichtung 1 als Schaltbild dargestellt. Der Bogenentladungserkennungseinrichtung 1 ist an der Stelle.2 ein Signal zugeführt, das im Ausführungsbeispiel proportional zur Ausgangsspannung einer Gleichstromversorgung ist, die einen Plasmaprozess mit Strom bzw. Spannung versorgt. Dieses Signal wird durch einen Spannungsteiler 3 weiter reduziert, so dass ein Momentanwert des zur Ausgangsspannung proportionalen Signals auf den- nicht invertierenden Eingang des als Operationsverstärker ausgebildeten Vergleichers 4 gegeben wird. Das an der Stelle 2 eingespeiste Signal wird außerdem an eine Extremwerterfassungseinrichtung 5 gegeben, wo über einen vorgegebenen Zeitraum ein Extremwert des an der Stelle 2 gespeisten Signals ermittelt wird. Über eine Einstetteinrichtung 6, die im Ausführungsbeispiel drei in Serie geschaltete Widerstände 7 bis 9 aufweist, und die mit den Widerständen 10, 11 einen Spannungsteiler bildet, wird ein Referenzwert eingestellt, der kleiner ist als der ermittelte Minimalwert, jedoch durch diesen bestimmt wird. Der Referenzwert wird dem invertierenden Eingang des Vergleichers 4 zugeführt und mit dem Momentanwert des zur Ausgangsspannung der Gleichstromversorgung proportionalen Werts verglichen. Fällt der Momentanwert unter den Referenzwert, so wird der Signalpegel eines an der Stelle 12 anliegenden Bogenentladungserkennungssignals geändert. Dieses Signal wird mit anderen Signalen verknüpft, so dass ein Arc-Signal erzeugt wird, welches an der Stelle 13 anliegt. Hat das Arc-Signal den Pegel "Low", so bedeutet dies, dass von der Steuerung eine Löschung des Arcs initiiert wurde. Das Ermitteln des Referenzwerts ist gleichbedeutend damit, dass der Momentanwert mit dem Extremwert verglichen wird und eine Abweichung ermittelt wird, die mit einer vorgegebenen, von dem Mininialwert bestimmten Abweichung verglichen wird. Der Signalpegel des Bogenentladungserkennungssignals wird geändert, wenn die ermittelte Abweichung die vorgegebene Abweichung. übersteigt.

Die Extremwerterfassungseinrichtung 5 weist einen zweistufigen Filter auf. Die erste Stufe des Filters weist ein RC-Glied bestehend aus dem Widerstand 11 und dem Kondensator 14 auf. Durch den Widerstand 11 und den Kondensator 14 wird eine erste Zeitkonstante definiert, die verwendet wird, wenn eine steigende Flanke des Signals, das an der Stelle 2 eingespeist wird, vorliegt. Parallel zum Widerstand 11 ist ein Widerstand 15 vorgesehen, der in Serie zu einem als Diode ausgebildeten nicht-linearen Bauteil 16 angeordnet ist. Der Widerstand 15 ist deutlich kleiner als der Widerstand 11. Durch den Widerstand 15 und den Kondensator 14 wird eine zweite Zeitkonstante definiert, die geringer ist als die erste Zeitkonstante und verwendet wird, wenn eine fallende Flanke des Signals vorliegt. Die zweite Stufe des Filters wird durch den Widerstand 10 und den Kondensator 17 gebildet, wobei der Kondensator 17 und der Widerstand 10 ein RC-Glied bilden. Parallel zum Widerstand 10 ist ein Widerstand 18 in Serie zu einem nicht-linearen Bauteil 19, das als Diode ausgebildet ist, vorgesehen. Auch durch die zweite Stufe des Filters wird in gleicher Weise wie bei der ersten Stufe eine erste Zeitkonstante für ein steigendes Signal und eine zweite Zeitkonstante für ein fallendes Signal verwendet. Im Ausführungsbeispiel wird durch den zweistufigen Filter der Extremwerterfassungseinrichtung 5 ein Minimalwert ermittelt. Durch die zweite Filterstufe wird die Restwelligkeit des durch die erste Filterstufe erzeugten Signals reduziert. Die Ermittlung eines Extremwerts kann durch eine als Transistor ausgebildete Abschalteinrichtung 20 unterbunden werden, die von einem Signal einer Plasmaerkennungseinrichtung, die an der Stelle 21 angeschlossen ist, gesteuert ist. Wird ein gezündetes Plasma erkannt, so hat das an der Stelle 21 eingespeiste Signal den Signalpegel "Low". Dies bedeutet, dass durch die als Transistor ausgebildete Abschalteinrichtung 20 das an der Stelle 2 eingespeiste Signal nicht auf Masse gezogen wird und dadurch eine Extremwertermittlung durch die Extremwerterfassüngseinrichtung 5 erfolgt. Wird dagegen erkannt, dass das Plasma nicht gezündet ist, liegt an der Abschalteinrichtung 20 ein Signalpegel "High" an, so dass das an der Stelle 2 eingespeiste Signal auf Masse gezogen wird und keine Extremwertbildung erfolgt.

Zwischen der Extremwerterfassungseinrichtung 5 und dem Vergleicher 4 ist ein erstes entkoppelndes Element 22 angeordnet, das als Diode ausgebildet ist. An der Stelle 23 wird ein fester Schwellenwert, im Ausführungsbeispiel eine Spannung, erzeugt bzw. angelegt, der über ein zweites entkoppelndes Element 24, das ebenfalls als Diode ausgebildet ist, eingekoppelt wird. Wenn die Spannung auf der Vergleicherseite des ersten entkoppelnden Elements 22 geringer ist als der feste Schwellenwert, so wird dieser Schwellenwert von dem Vergleicher 4 als Referenzsignal zum Vergleich verwendet. Fällt der Momentanwert des Signals unter den Schwellenwert, so wird durch das Bogenentladungserfassungssignal ein Arc angezeigt. Dies bedeutet, dass ein Arc auch erkannt werden kann, wenn der Signalpegel des an der Stelle 2 eingekoppelten Signals langsam fällt und somit sehr niedrige Minimalwerte durch die Extremwerterfassungseinrichtung 5 ausgegeben werden.

Es ist weiterhin eine geschaltete Hystereseschaltung 25 vorgesehen, der an der Stelle 13 das Arc-Signal zugeführt ist. Hat das Arc-Signal einen Signalpegel "Low", der einer Arc-Löschung entspricht, so ist der Transistor 26 nichtleitend und dadurch der Transistor 27 leitend. Durch diese Maßnahme werden die Widerstände 28, 29 parallel geschaltet, so dass eine weitere Spannungsteilung erfolgt. Der Momentanwert des an der Stelle 2 eingekoppelten Signals wird daher weiter erniedrigt, so dass erst bei einem Anstieg der an der Stelle 2 eingespeisten Spannung, der oberhalb eines Schwellenwertes liegt, der Signalpegel des Bogenentladungserkennungssignals an der Stelle 12 wieder zurückgesetzt wird. Durch diese Maßnahme wird eine Hysterese realisiert und sichergestellt, dass der Arc beim Zurücksetzen des Bogenentladungserkennungssignals erloschen ist.

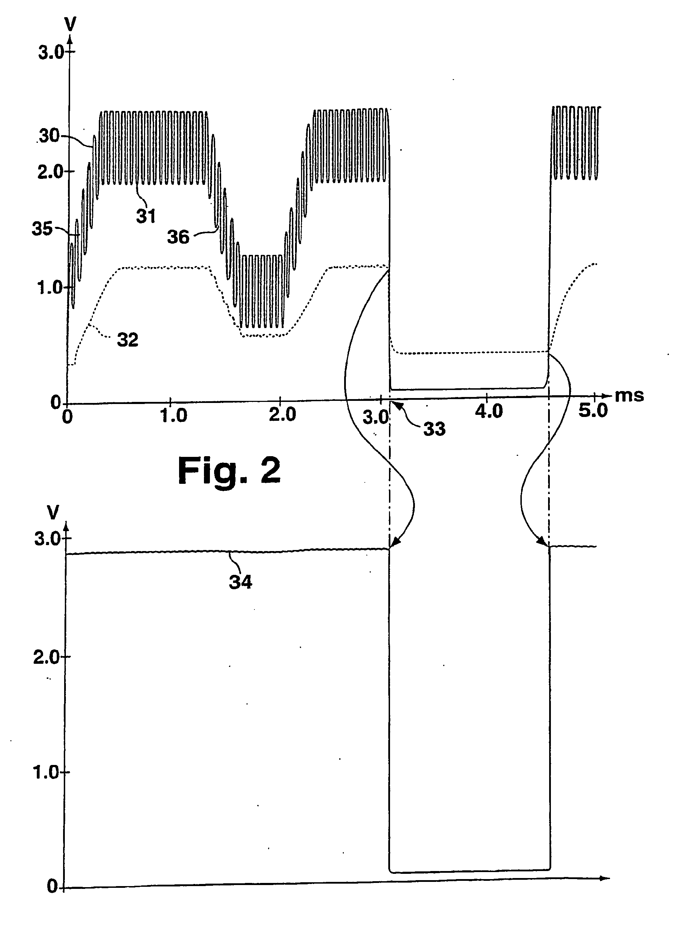

In der **Fig. 2****.** ist ein Simulationsergebnis der Schaltung gemäß Fig. 1 dargestellt. Mit 30 ist der Signalverlauf des Signals dargestellt, das am nicht invertierenden Eingang des Vergleichers 4 anliegt. Das Signal 30 weist eine starke Welligkeit auf. Über einen vorgegebenen Zeitraum werden die Minimalwerte 31 des Signals 30 ermittelt. In der dargestellten Zeichnung ist der Minimalwert im Bereich von etwa 0,2 bis 1,4 ms etwa 1,8 V. Aus diesem Minimalwert wird ein Referenzwert 32, gebildet, wobei der Referenzwert etwa 67 % des Minimalwerts 31 ist. Unterschreitet, der Momentanwert des Signals 30 den Referenzwert 32, wie dies an der Stelle 33 dargestellt ist, so wechselt der Signalpegel des Bogenentladungserkennungssignals 34, das in der Fig. 1 an der Stelle 12 anliegt. Das Bogenentladungserkennungssignal 34 wird der Steuerung zugeführt, die ihrerseits das Arc-Signal, das in Fig. 1 an Stelle 13 anliegt, zeitverzögert oder sofort und abhängig von weiteren Steuersignalen erzeugt. Die Arc-Erkennung, wenn der Momentanwert unter den Referenzwert 32 fällt, ist gleichbedeutend damit, dass der Signalwert mit dem ermittelten Minimalwert verglichen wird und der Pegel des ArcSignals 34 geändert wird, wenn die Differenz aus Minimalwert und Momentanwert größer wird als eine vorgegebene Abweichung, die im Ausführungsbeispiel dem 0,33-fachen Minimalwert entspricht. Aus der Fig. 2 ist ersichtlich, dass der Referenzwert 32 sich mit veränderndem Minimalwert 31 ebenfalls verändert. Somit erfolgt eine Anpassung. Die Filterung bewirkt, dass schnelle Spannungsänderungen, beispielsweise Sollwertsprünge, wie dies an den Stellen 35 und 36 der Fall ist, nicht fehlerhaft als Arcs interpretiert werden. Für die Filterung der steigenden Flanke des Signals 30 an der Stelle 35 wird eine andere Zeitkonstante verwendet als für die fallende Flanke bei 36.

In der Fig. 2 ist ebenfalls erkennbar, dass bei einem erkannten Arc das Signal 30, im vorliegenden Fall die Spannung, einbricht. Dies bedeutet auch, dass der Referenzwert 32 zu niedrigen Werten nachgezogen wird. Der Referenzwert 32 bleibt jedoch im Zeitbereich nach der Stelle 33 bei einem gewissen Wert "hängen". Dieser Wert entspricht dem eingekoppelten Schwellenwert. Wenn dieser Schwellenwert überschritten wird, wird auch der Pegel des Arc-Signals 34 wieder geändert.

Eine Bogenentladungserkennungseinrichtung 1 zum Erkennen von Bogenentladungen in einem Plasmaprozess umfasst einen Vergleicher 4, dem ein Signal und ein Referenzwert zugeführt sind, wobei der Referenzwert durch' eine Einstelleinrichtung 6 aus dem durch eine Extremwerterfassungseinrichtung 5 in einem vorgegebenen Zeitraum ermittelten Extremwert des Signals gebildet ist, und der Vergleicher 4 den Zustand eines Bogenentladungserkennungssignals ändert, wenn der Vergleich des Referenzwerts mit einem Momentanwert des Signals ergibt, dass eine Bogenentladung aufgetreten ist.

## Patentansprüche

1. Verfahren zum Erkennen von Bogenentladungen in einem Plasmaprozess, bei dem in einem vorgegebenen Zeitraum ein Extremwert (31) eines Signals (30) ermittelt wird und eine Bogenentladung detektiert wird, wenn der Vergleich des ermittelten Extremwerts (31) mit einem Momentanwert des Signals (30) oder eines dazu proportionalen Werts ergibt, dass die Abweichung des Momentanwerts oder des dazu proportionalen Werts von dem Extremwert (31) eine vorgegebene Abweichung übersteigt oder wenn durch den Momentanwert oder den dazu proportionalen Wert ein aus der vorgegebenen Abweichung und dem Extremwert (31) ermittelter Referenzwert (32) erreicht wird.

2. Verfahren nach Anspruch 1, **dadurch gekennzeichnet, dass** die vorgegebene Abweichung in Abhängigkeit des Extremwerts (31) ermittelt wird.

3. Verfahren nach Anspruch 2, **dadurch gekennzeichnet, dass** die Abweichung als das 0,1 - 0,5 fache, vorzugsweise das 0,2 - 0,4 fache, des Extremwerts (31) gewählt wird.

4. Verfahren nach einem der vorhergehenden Ansprüche, **dadurch gekennzeichnet, dass** als Signal (30) ein zu einer Ausgangsspannung oder einem Ausgangsstrom einer Gleichspannungsversorgung proportionales Signal verwendet wird.

5. Verfahren nach einem der vorhergehenden Ansprüche, **dadurch gekennzeichnet, dass** der Extremwert (31) ermittelt wird, indem das Signal (30) gefiltert wird.

6. Verfahren nach Anspruch 5, **dadurch gekennzeichnet, dass** eine Minimalwertfilterung durchgeführt wird.

7. Verfahren nach Anspruch 5 oder 6, **dadurch gekennzeichnet, dass** die Filterung für steigende und fallende Signalwerte mit unterschiedlichen Zeitkonstanten durchgeführt wird.

8. Verfahren nach einem der vorhergehenden Ansprüche, **dadurch gekennzeichnet, dass** überwacht wird, ob das Plasma des Plasmaprozess gezündet ist.

9. Verfahren nach Anspruch 8, **dadurch gekennzeichnet, dass** eine Bogenentladungserkennung nur durchgeführt wird, wenn erkannt ist, dass das Plasma gezündet ist.

10. Verfahren nach Anspruch 8 oder 9, **dadurch gekennzeichnet, dass** die Extremwertfilterung bei gezündetem Plasma mit einer ersten Zeitkonstante und bei erloschenem Plasma mit einer zweiten Zeitkonstante erfolgt.

11. Verfahren nach einem der vorhergehenden Ansprüche, **dadurch gekennzeichnet, dass** ein fester Schwellenwert (23) vorgegeben wird und eine Bogenentladung erkannt wird, wenn der Momentanwert den festen Schwellenwert (23) erreicht.

12. Verfahren nach einem der vorhergehenden Ansprüche, **dadurch gekennzeichnet, dass** bei Erkennen einer Bogenentladung der Signal-pegel eines Bogenentladungserkennungssignals geändert wird.

13. Verfahren nach Anspruch 12, **dadurch gekennzeichnet, dass** der Signalpegel des Bogenentladungserkennungssignals zeitverzögert geändert wird, wenn die Bogenentladung erlischt.

14. Bogenentladungserkennungseinrichtung (1) zur Durchführung des Verfahrens nach einem der vorhergehenden Ansprüche, der im Betrieb ein Signal, zugeführt wird und die einen ein Bogenentladungserkennungssignal ausgebenden Vergleicher (4), eine Extremwerterfassungseinrichtung (5) zum Ermitteln eines Extremwerts des Signals in einem vorgegebenen Zeitraum und eine Einstelleinrichtung (6) aufweist, **dadurch gekennzeichnet, dass** die Einstelleinrichtung (6) eingerichtet ist, ein Referenzsignal aus dem Extremwert zu erzeugen, wobei dem Vergleicher (4) das Referenzsignal ebenso wie ein Momentanwert des Signals oder ein dazu proportionaler Wert zugeführt wird und der Vergleicher (4) eingerichtet ist, den Signalpegel des Bogenentladungserkennungssignals zu ändern, wenn der Vergleicher (4) ein Erreichen des Referenzsignals durch den Momentanwert oder den dazu proportionalen Wert erkennt.

15. Bogenentladungserkennungseinrichtung nach Anspruch 14, **dadurch gekennzeichnet, dass** die Extremwerterfassungseinrichtung (5) eine Filtereinrichtung umfasst.

16. Bogenentladungserkennungseinrichtung nach Anspruch 15, **dadurch gekennzeichnet, dass** die Filtereinrichtung ein RC-Glied (11, 14; 10, 17) aufweist, wobei parallel zu dem Widerstand (11; 10) des RC-Glieds (11, 14; 10, 17) ein zweiter Widerstand (15, 18) und ein dazu in Serie geschaltetes nichtlineares Bauteil (16; 19), vorzugsweise eine Diode, vorgesehen sind.

17. Bogenentladungserkennungseinrichtung nach Anspruch 15 oder 16,
**dadurch gekennzeichnet, dass** die Filtereinrichtung mehrstufig ausgebildet ist.

18. Bogenentladungserkennungseinrichtung nach einem der vorhergehenden Ansprüche 14 bis 17, **dadurch gekennzeichnet, dass** zwischen der Extremwerterfassungseinrichtung (5) und dem Vergleicher (4) ein erstes entkoppelndes Bauelement (22), insbesondere eine Diode, angeordnet ist, und zwischen dem ersten entkoppelnden Element (22) und dem Vergleicher (4) über ein zweites entkoppelndes Element (24), insbesondere eine Diode, ein fester Schwellenwert (23), insbesondere eine Spannung, eingekoppelt ist.

19. Bogenentladungserkennungseinrichtung nach einem der vorhergehenden Ansprüche 14 bis 18, **dadurch gekennzeichnet, dass** eine Hystereseschaltung (25) zur Beeinflussung des an den Vergleicher (4) gegebenen Momentanwerts des Signals (30) vorgesehen ist.

20. Bogenentladungserkennungseinrichtung nach einem der vorhergehenden Ansprüche 14 bis 19, **dadurch gekennzeichnet, dass** eine Plasmaerkennungseinrichtung vorgesehen ist, die mit einer Abschalteinrichtung (20) zur Abschaltung der Bogenentladungserkennungseinrichtung (1) verbunden ist.

## Claims

1. Method of detecting arc discharges in a plasma process, in which an extreme value (31) of a signal (30) is determined in a predetermined time period and an arc discharge is detected when the comparison of the determined extreme value (31) with an instantaneous value of the signal (30) or of a value proportional thereto reveals that the deviation of the instantaneous value or the value proportional thereto from the extreme value (31) exceeds a predetermined deviation or when the instantaneous value or the value proportional thereto reaches a reference value (32) determined from the predetermined deviation and the extreme value (31).

2. Method according to claim 1, **characterised in that** the predetermined deviation is determined in dependence on the extreme value (31).

3. Method according to claim 2, **characterised in that** the deviation is chosen as from 0.1 to 0.5 times, preferably from 0.2 to 0.4 times, the extreme value (31).

4. Method according to any one of the preceding claims, **characterised in that** there is used as the signal (30) a signal proportional to an output voltage or an output current of a DC supply.

5. Method according to any one of the preceding claims, **characterised in that** the extreme value (31) is determined by filtering the signal (30).

6. Method according to claim 5, **characterised in that** minimum value filtering is carried out.

7. Method according to claim 5 or 6, **characterised in that** the filtering is carried out with different time constants for increasing and falling signal values.

8. Method according to any one of the preceding claims, **characterised in that** the ignition of the plasma of the plasma process is monitored.

9. Method according to claim 8, **characterised in that** an arc discharge detection is carried out only when it is detected that the plasma is ignited.

10. Method according to claim 8 or 9, **characterised in that** the extreme value filtering is carried out with a first time constant when the plasma is ignited and with a second time constant when the plasma is extinguished.

11. Method according to any one of the preceding claims, **characterised in that** a fixed threshold value (23) is given and an arc discharge is detected when the instantaneous value reaches the fixed threshold value (23).

12. Method according to any one of the preceding claims, **characterised in that**, when an arc discharge is detected, the signal level of an arc discharge detection signal is changed.

13. Method according to claim 12, **characterised in that** the signal level of the arc discharge detection signal is changed with a time delay when the arc discharge is extinguished.

14. Arc discharge detection device (1) for carrying out the method according to any one of the preceding claims, to which device a signal is fed during operation and which comprises a comparator (4) which emits an arc discharge detection signal, an extreme value detection device (5) for determining an extreme value of the signal in a predetermined time period, and an adjustment device (6), **characterised in that** the adjustment device (6) is configured to produce a reference signal from the extreme value, wherein the reference signal as well as an instantaneous value of the signal or a value proportional thereto are fed to the comparator (4) and the comparator (4) is configured to change the signal level of the arc discharge detection signal when the comparator (4) detects that the instantaneous value or the value proportional thereto has reached the reference signal.

15. Arc discharge detection device according to claim 14, **characterised in that** the extreme value detection device (5) comprises a filter device.

16. Arc discharge detection device according to claim 15, **characterised in that** the filter device comprises an RC member (11, 14; 10, 17), wherein there are provided parallel to the resistor (11; 10) of the RC member (11, 14; 10, 17) a second resistor (15, 18) and a non-linear component (16; 19), preferably a diode, connected in series therewith.

17. Arc discharge detection device according to claim 15 or 16, **characterised in that** the filter device is in multi-stage form.

18. Arc discharge detection device according to any one of the preceding claims 14 to 17, **characterised in that** a first decoupling component (22), in particular a diode, is arranged between the extreme value detection device (5) and the comparator (4), and a fixed threshold value (23), in particular a voltage, is coupled between the first decoupling element (22) and the comparator (4) by way of a second decoupling element (24), in particular a diode.

19. Arc discharge detection device according to any one of the preceding claims 14 to 18, **characterised in that** a hysteresis circuit (25) for influencing the instantaneous value of the signal (30) given to the comparator (4) is provided.

20. Arc discharge detection device according to any one of the preceding claims 14 to 19, **characterised in that** there is provided a plasma detection device which is connected to a switch-off device (20) for switching off the arc discharge detection device (1).

## Revendications

1. Procédé de détection de décharges en arc dans un procédé plasma, dans lequel une valeur extrême (31) d'un signal (30) est déterminée dans un laps de temps prédéfini et une décharge en arc est détectée lorsque la comparaison de la valeur extrême (31) déterminée avec une valeur momentanée du signal (30) ou une valeur proportionnelle à celle-ci donne pour résultat que l'écart entre la valeur momentanée ou la valeur proportionnelle à celle-ci et la valeur extrême (31) dépasse un écart prédéfini ou lorsqu'une valeur de référence (32) déterminée à partir de l'écart prédéfini et de la valeur extrême (31) est atteinte par la valeur momentanée ou la valeur proportionnelle à celle-ci.

2. Procédé selon la revendication 1, **caractérisé en ce que** l'écart prédéfini est déterminé en fonction de la valeur extrême (31).

3. Procédé selon la revendication 2, **caractérisé en ce que** l'écart est choisi égal à 0,1 à 0,5 fois, de préférence à 0,2 à 0,4 fois la valeur extrême (31).

4. Procédé selon une des revendications précédentes, **caractérisé en ce qu'**un signal proportionnel à une tension de sortie ou à un courant de sortie d'une alimentation en tension continue est utilisé comme signal (30).

5. Procédé selon une des revendications précédentes, **caractérisé en ce que** la valeur extrême (31) est déterminée en filtrant le signal (30).

6. Procédé selon la revendication 5, **caractérisé en ce qu'**un filtrage de valeur minimale est effectué.

7. Procédé selon la revendication 5 ou 6, **caractérisé en ce que** le filtrage est effectué avec des constantes de temps différentes pour les valeurs de signal montantes et descendantes.

8. Procédé selon une des revendications précédentes, **caractérisé en ce qu'**il est surveillé si le plasma du procédé plasma est amorcé.

9. Procédé selon la revendication 8, **caractérisé en ce qu'**une détection de décharges en arc est effectuée seulement s'il est détecté que le plasma est amorcé.

10. Procédé selon la revendication 8 ou 9, **caractérisé en ce que** le filtrage de valeur extrême est effectué avec une première constante de temps lorsque le plasma est amorcé et avec une deuxième constante de temps lorsque le plasma est éteint.

11. Procédé selon une des revendications précédentes, **caractérisé en ce qu'**une valeur seuil fixe (23) est prédéfinie et une décharge en arc est détectée lorsque la valeur momentanée atteint la valeur seuil fixe (23).

12. Procédé selon une des revendications précédentes, **caractérisé en ce qu'**en cas de détection d'une décharge en arc, le niveau de signal d'un signal de détection de décharges en arc est modifié.

13. Procédé selon la revendication 12, **caractérisé en ce que** le niveau de signal du signal de détection de décharges en arc est modifié avec retard lorsque la décharge en arc s'éteint.

14. Dispositif de détection de décharges en arc (1) pour réaliser le procédé selon une des revendications précédentes, auquel un signal est amené en fonctionnement et qui présente un comparateur (4) délivrant un signal de détection de décharges en
arc, un dispositif de détection de valeur extrême (5) pour déterminer une valeur extrême du signal dans un laps de temps prédéfini et un dispositif de réglage (6), **caractérisé en ce que** le dispositif de réglage (6) est conçu pour générer un signal de référence à partir de la valeur extrême, le signal de référence ainsi qu'une valeur momentanée du signal ou une valeur proportionnelle à celle-ci étant amenés au comparateur (4) et le comparateur (4) étant conçu pour modifier le niveau de signal du signal de détection de décharges en arc lorsque le comparateur (4) détecte que la valeur momentanée ou la valeur proportionnelle à celle-ci atteint le signal de référence.

15. Dispositif de détection de décharges en arc selon la revendication 14, **caractérisé en ce que** le dispositif de détection de valeur extrême (5) comprend un dispositif de filtrage.

16. Dispositif de détection de décharges en arc selon la revendication 15, **caractérisé en ce que** le dispositif de filtrage présente un circuit RC (11, 14 ; 10, 17), une deuxième résistance (15, 18) et un élément non linéaire (16 ; 19) monté en série avec celle-ci, de préférence une diode, étant prévus en parallèle sur la résistance (11 ; 10) du circuit RC (11, 14 ; 10, 17).

17. Dispositif de détection de décharges en arc selon la revendication 15 ou 16, **caractérisé en ce que** le dispositif de filtrage est réalisé à plusieurs étages.

18. Dispositif de détection de décharges en arc selon une des revendications précédentes 14 à 17, **caractérisé en ce qu'**un premier élément de découplage (22), en particulier une diode, est disposé entre le dispositif de détection de valeur extrême (5) et le comparateur (4), et une valeur seuil fixe (23), en particulier une tension, est couplée via un deuxième élément de découplage (24), en particulier une diode, entre le premier élément de découplage (22) et le comparateur (4).

19. Dispositif de détection de décharges en arc selon une des revendications précédentes 14 à 18, **caractérisé en ce qu'**il est prévu un circuit à hystérésis (25) pour influencer la valeur momentanée du signal (30) amenée au comparateur (4).

20. Dispositif de détection de décharges en arc selon une des revendications précédentes 14 à 19, **caractérisé en ce qu'**il est prévu un dispositif de détection de plasma, lequel est relié à un dispositif de coupure (20) pour couper le dispositif de détection de décharges en arc (1).
